# EUROPEAN PATENT SPECIFICATION

(11) **EP 1 126 618 B1**
(45) Date of publication and mention of the grant of the patent: **29.10.2003**
(21) Application number: 01103754.6
(22) Date of filing: 15.02.2001
(51) Int. Cl.: H03L 7/099, H03K 5/156

(54) **Clock signal generator and communication device using the same**
Taktsignalgenerator und diesen benutzende Datenübertragungsschaltung
Générateur de signal d'horloge et dispositif de communication l'incorporant

(30) Priority: 17.02.2000 JP 2000039510
(43) Date of publication of application: 22.08.2001
(73) Proprietor: MATSUSHITA ELECTRIC INDUSTRIAL CO., LTD., Kadoma-shi, Osaka-fu 571 (JP)
(72) Inventor: Nishio, Takatoshi, Hirakata-shi, Osaka (JP); Tabira, Yoshihiro, Osaka-shi, Osaka (JP); Kau, Stefan,, 55411 Bingen (DE); Kiefner, Marcus, 64297 Darmstadt (DE)
(74) Representative: Grünecker, Kinkeldey, Stockmair & Schwanhäusser Anwaltssozietät

(56) References cited:
- EP-A- 0 630 129
- US-A- 4 807 156
- US-A- 5 578 968
- U.TIETZE, CH. SCHENK: "Halbleiterschaltungstechnik - Fünfte, überarbeitete Auflage" 1980 , SPRINGER VERLAG , BERLIN HEIDELBERG NEW YORK XP002168817 * page 572 - page 580 *
- BUNDGARD T: "BUILD A CYCLE-STEALING RATIO DIVIDER" ELECTRONIC DESIGN,PENTON PUBLISHING, CLEVELAND, OH,US, vol. 47, no. 11, 31 May 1999 (1999-05-31), pages 72-73, XP000912414 ISSN: 0013-4872

## Description

### BACKGROUND OF THE INVENTION

The present invention relates to a clock signal generator for generating a desired clock signal by adding a peripheral circuit to clock signal generating means and communications apparatus using the clock signal generator.

Asynchronous communications such as RS-232C are widely known and used in a variety of fields. Asynchronous communications are an essential feature for personal computers. A precise clock signal is required also in asynchronous communications. A variety of clock signal generators have been developed and added to a library.

In case asynchronous communications are carried out by using a conventional clock signal generator that has been added to a library, a desired clock signal thus a correct baud rate may not be obtained by frequency division. For example, according to the RS-232C specifications (EIA/TIA-22-E), a maximum transfer rate is 20 kbps although the transfer rate exceeds this limit in practice. This may cause problems such as a communication error thus requesting re-design of the entire communications apparatus.

While re-designing a clock signal generator can customize the frequency division feature of the clock signal and a precise baud rate can be obtained, a considerable increase in the number of development man-hours and another trouble may be caused by a new design.

The article "Build A Cycle-Stealing Ratio Divider" by Bundgard T (Electronic Design, Penton Publishing, Cleveland, OH, US, vol. 47, no. 11, May 31, 1999), pages 72-73, shows a cycle-stealing ratio divider, which is used to produce multiple individual frequencies from a base frequency f. The document shows a simple technique using standard digital components, such as the counter IC Intel 8254 to produce discrete frequencies with jitter and accuracy comparable to those of a typical phase-locked-loop implementation using standard digital components.

### SUMMARY OF THE INVENTION

The invention, in view of the aforementioned problems, aims at reducing the number of man-hours required for custom design of a clock signal generator, by having a configuration where an additional circuit is incorporated into an existing highly reliable clock signal generator circuit and an intermittent clock signal is generated to obtain a baud rate, instead of making a design by customizing a clock signal generator circuit for generating a clock signal whose frequency is constant.

In order to solve the aforementioned problems, a cycle stealing ratio divider is provided as defined in the appended claims.

### BRIEF DESCRIPTION OF THE DRAWINGS

Fig. 1 is a block diagram of communications apparatus according to embodiment 1 of the invention.
Fig. 2 is a first timing chart explaining the operation of the communications apparatus shown in Fig. 1.
Fig. 3 is a second timing chart explaining the operation of the communications apparatus shown in Fig. 1.
Fig. 4 is a third timing chart explaining the operation of the communications apparatus shown in Fig. 1.
Fig. 5 is a block diagram of communications apparatus according to embodiment 2 of the invention.
Fig. 6 is a timing chart explaining the operation of the communications apparatus shown in Fig. 5.
Fig. 7 is a block diagram of communications apparatus according to embodiment 3 of the invention.
Fig. 8 is a timing chart explaining the operation of the communications apparatus shown in Fig. 7.

### DETAILED DESCRIPTION OF THE PREFERRED EMBODIMENTS

Embodiments of the invention will be described referring to the drawings.

### (Embodiment 1)

A clock signal generator and communications apparatus using the cycle stealing ratio divider according to embodiment 1 regenerates a baud rate clock signal by correcting a clock output by an existing clock generator circuit in generating a clock signal. Thus, the number of man-hours required for custom design of a clock signal generator is reduced in designing communications apparatus.

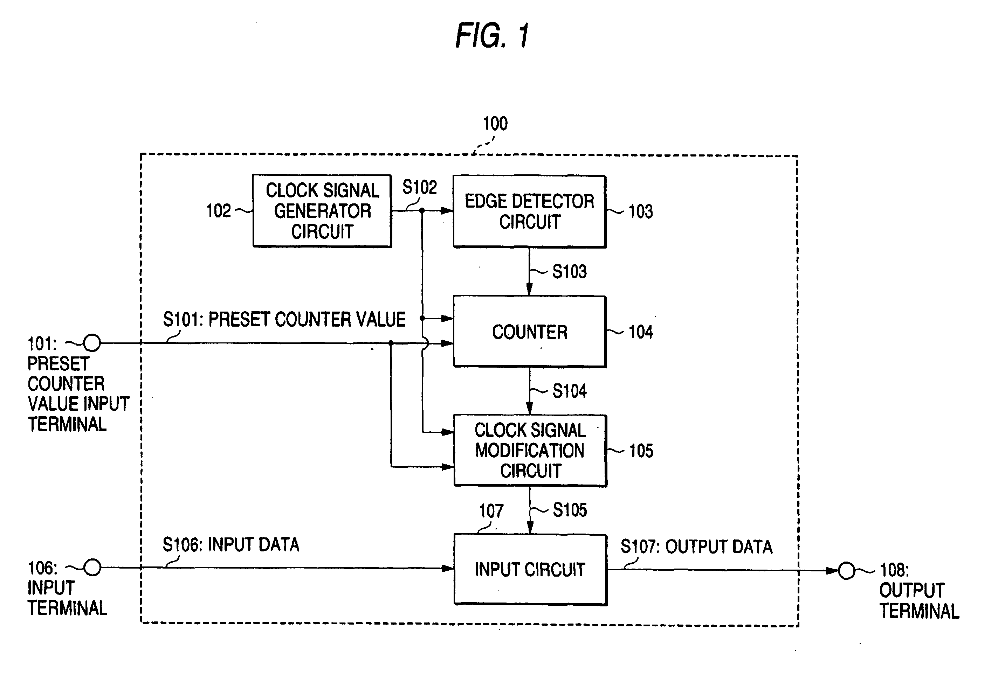

A clock signal generator and communications apparatus using the clock signal generator according to embodiment 1 will be described referring to Figs. 1 through 4.

Fig. 1 is a block diagram of a clock signal generator and communications apparatus using the clock signal generator according to embodiment 1 of the invention. The communications apparatus 100 is composed of a preset counter value input terminal 101, a clock signal generator circuit 102, an edge detector circuit 103, a counter 104, a clock signal modification circuit 105, an input terminal 106, an input circuit 107, and an output terminal 108.

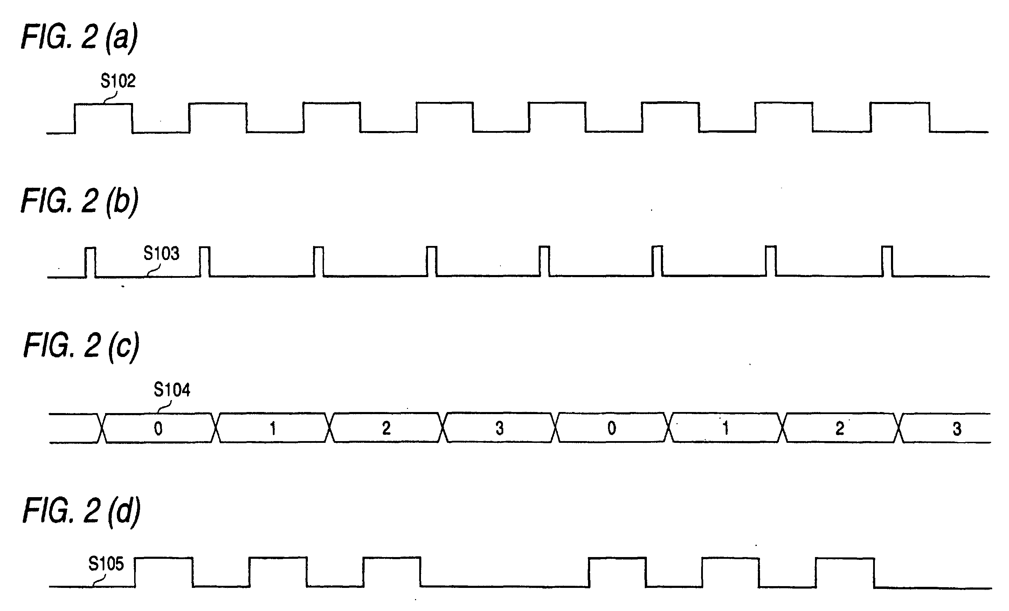

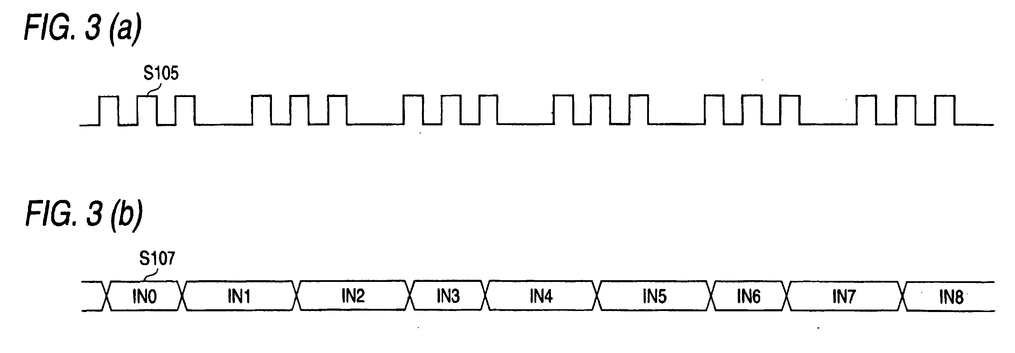

Operation of the clock signal generator and the communications apparatus using the clock signal generator will be described. As shown in Fig. 2, the edge detector circuit 103, on detecting the rising edge of an original clock signal S102 generated by the clock signal generator circuit 102, outputs a High signal as an edge signal to the counter 104. The counter 104 is incremented when an edge signal S103 is input. The counter 104 is zero-cleared when the counter value S104 becomes identical with the preset counter value S101. The clock signal modification circuit 105 masks the original clock signal S102 in case the counter value S104 is identical with the preset counter value S101. Otherwise, the clock signal modification circuit 105 outputs a baud rate control clock signal S105 to the input circuit 107 without masking the original clock signal S102. With the timing shown in Fig. 3, the input circuit 107 latches input data S106 per predetermined rising edge of the baud rate control clock signal S105 and sequentially outputs the input data S106 to an external data output terminal 108.

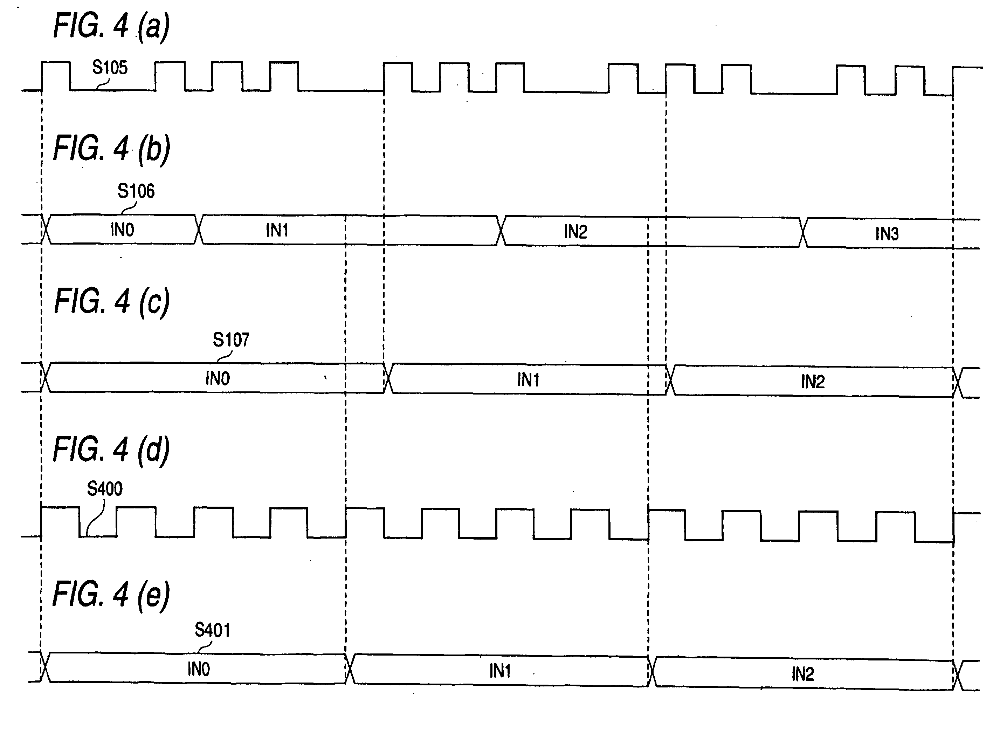

In this embodiment, a baud rate is realized via accuracy of the baud rate clock signal alone by generating an intermittent baud rate clock signal, instead of using a 4/3-times clock signal. Fig. 4 is a timing chart comparing the case where the input signal S106 is captured via a precision clock signal S400 (S401) and the case where the input signal S106 is captured via a baud rate control clock signal S105 (107) in case the precision clock signal S400 as a 4/3-times clock signal is generated with a clock signal generator circuit customized. As understood from comparison between S107 and S401, capture timing completely matches at 12 cycles for the output baud rate control clock signal and the precision clock signal. This eliminates the effects of capturing jitter caused by an intermittent signal.

As mentioned earlier, a desired baud rate is realized by performing communications via a baud rate clock signal regenerated using an intermittent clock signal even when conventional communications apparatus whose baud rate clock signal is less accurate. Such a configuration uses only a circuit that generates an intermittent clock signal for compensation. Thus the number of man-hours required for designing a customized clock signal generator circuit is drastically reduced.

While data input from the baud rate clock signal is specified as shown in Figs. 3 and 4, this invention is not limited to this configuration. While the clock signal modification circuit processes a delayed input baud rate control clock signal, the delay amount is variable and it is possible to process an input baud rate control clock signal without delay.

### (Embodiment 2)

A clock signal generator and communications apparatus using the cycle stealing ratio divider according to embodiment 2 of the invention is characterized in that the frequency range where a baud rate clock signal can be corrected is extended without substantially enhancing the circuit scale.

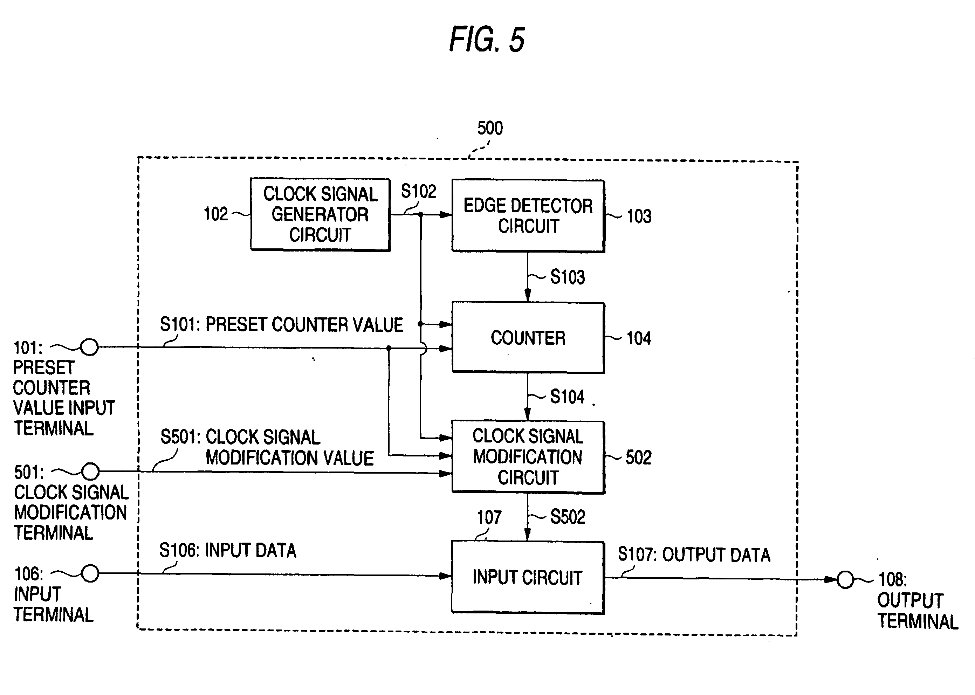

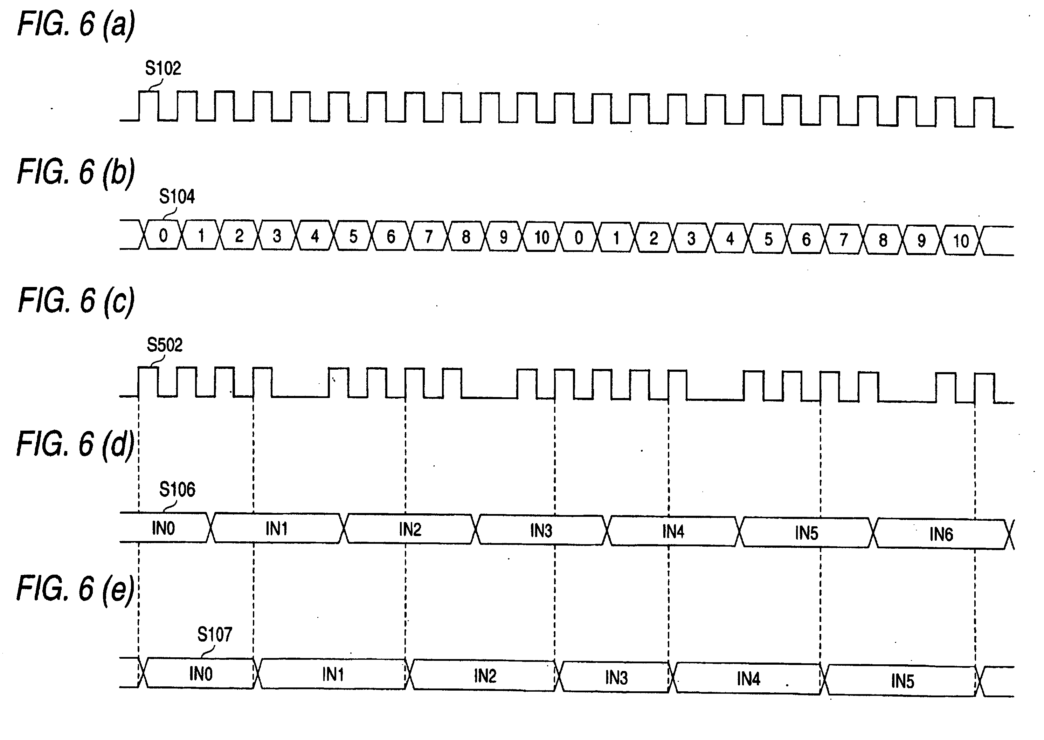

A clock signal generator and communications apparatus using the cycle stealing ratio divider according to embodiment 2 will be described referring to Figs. 5 and 6.

Fig. 5 is a block diagram of a clock signal generator and communications apparatus using the clock signal generator according to embodiment 2 of the invention. In Fig. 5, the same reference numerals correspond to those in Fig. 1. Configuration in Fig. 5 differs from that in Fig. 1 in that a clock signal modification terminal 501 is additionally provided and that the clock modification circuit 105 is replaced with a clock signal modification circuit 502. The clock signal modification circuit 502 generates the baud rate control clock signal S502 by masking the rising edge of the original clock signal S102 when the counter value S104 has reached a clock signal modification value S502.

Fig. 6 shows the operation of the clock signal generator and the communications apparatus using the clock signal generator. Assume that 10 is input as a preset counter value S101 and 4 and 9 are input as clock signal modification values S501. The clock signal modification circuit 502 masks the original clock signal S102 in the case of counter values 4 and 9 and generates the baud rate control clock signal S502. The input circuit 107 sequentially captures input data S106 every three cycles of the rising edge of the baud rate control clock signal S502, then outputs the captured data as output data S107.

In this embodiment, a baud rate is realized via accuracy of the baud rate clock signal alone by generating an intermittent baud rate clock signal from a clock generator circuit, instead of using a 9/11 time clock signal.

As mentioned earlier, an existing clock signal generator circuit is used to generate a baud rate clock signal thus reducing the number of man-hours required for customizing a clock signal generator circuit. Interval of intermittence of a clock signal is externally input so that the baud rate compensation range can be substantially extended, compared with the case in embodiment 1.

### (Embodiment 3)

A clock signal generator and communications apparatus using the clock signal generator according to embodiment 3 of the invention modulates a clock signal output by an existing clock generator circuit in generating a clock signal for controlling the baud rate.

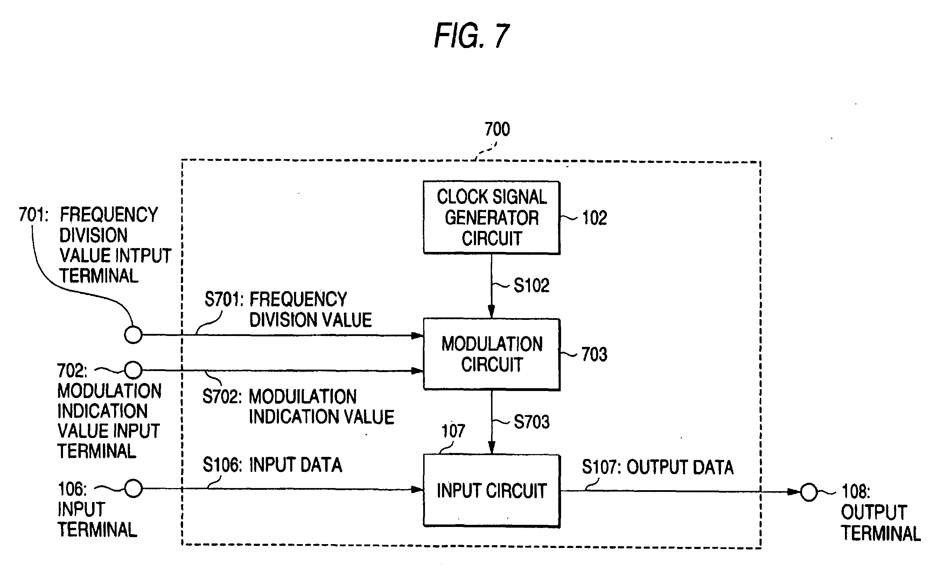

Fig. 7 is a block diagram of the clock signal generator and the communications apparatus using the clock signal generator according to embodiment 3 of the invention. In Fig. 7, communications apparatus 700 comprises a frequency division value input terminal 701, a modulation indication value input terminal 702, and a modulation circuit 703. The remaining sections correspond to those having the same signs in embodiment 1.

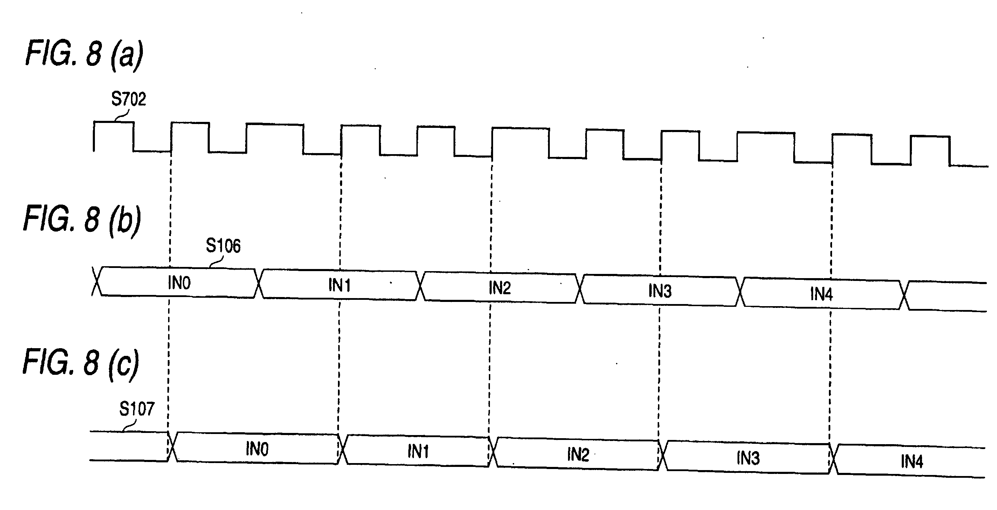

Fig. 8 is a timing chart explaining the operation of the clock signal generator and the communications apparatus using the clock signal generator shown in Fig. 7. The frequency division circuit divides the frequency of an original clock signal S102 generated in the clock signal generator circuit 102 based on the frequency division value S701. The modulation circuit 703, on obtaining the modulation indication value S702, for example information (frequency, degree of modulation)=(3, 1), outputs a baud rate clock signal whose signal cycles are incremented by one once in three times, as shown in Fig. 8. The input circuit 107 captures input data S106 via the baud rate clock signal S703.

While the modulation indication value is (frequency, degree of modulation) in embodiment 3, the invention is not limited to this but either or both of the frequency and the degree of modulation may be limited to a predetermined amount and external input may not be required. The degree of modulation can be realized via the falling edge or plus or minus level of a reference clock signal, or via another clock signal.

While communications apparatus in embodiments 1 through 3 assumes reception only, communications apparatus that performs transmission and reception may be implemented. The same advantage is obtained in case the clock signal frequency of the reference clock signal and that of a clock signal for controlling the baud rate are known, even when both signals are not synchronized.

As mentioned earlier, a clock signal generator and communications apparatus using the clock signal generator according to the invention has a configuration where an intermittent clock signal having a desired frequency is obtained by adding a peripheral circuit to an existing clock signal generator. This eliminates the need for designing a dedicated clock signal generator for generating a frequency required per communications apparatus, thus reducing the number of man-hours required for design of communications apparatus.

## Claims

1. A cycle stealing ratio divider to generate an output signal (S502) of predetermined frequency, comprising:
a clock signal generation means (102) for generating a dock signal (S102) of consecutive docks at a predetermined frequency,
a counting means (104) for outputting a counter value (S104) counting the clocks of said clock signal (S102), wherein said counter value (S104) is reset upon reaching a preset counter value (S101),
a masking means (105) connected to said counting means (104) for receiving said counter value (S104) and for outputting said output signal (S502), wherein said masking means (105) is adapted to receive said dock signal (S102) from said dock signal generation means (102) and to receive a plurality of clock signal modification values (S501), wherein a dock of said clock signal (S102) is masked by said masking means (105) in case one of said clock signal modification values (S501) equals the current counter value (S104).

2. A communication apparatus adapted to perform data input/output using a signal generated by a cycle stealing ratio divider according to claim 1.

## Patentansprüche

1. Cycle-Stealing-Ratio-Dividierer zum Erzeugen eines Ausgabesignals (S502) vorgegebener Frequenz, umfassend:
eine Taktsignal-Erzeugungseinrichtung (102) zum Erzeugen eines Taktsignals (S102) von in einer vorgegebenen Frequenz aufeinander folgenden Takten,
eine Zähleinrichtung (104) zur Ausgabe eines die Takte des Taktsignals (S102) zählenden Zählwertes (S104), wobei der Zählwert (S104) bei Erreichen eines vorgegebenen Zählwertes (S101) rückgesetzt wird,
eine Maskierungseinrichtung (105), verbunden mit der Zähleinrichtung (104), zum Empfangen des Zählwertes (S104) und zur Ausgabe des Ausgabesignals (S502), wobei die Maskierungseinrichtung (105) geeignet ist, um das Taktsignal (S102) von der Taktsignal-Erzeugungseinrichtung (102) zu empfangen und eine Vielzahl von Taktsignal-Modifizierungswerten (S501) zu empfangen, wobei ein Takt des Taktsignals (S102) für den Fall, dass einer der Taktsignal-Modifizierungswerte (S501) dem aktuellen Zählwert entspricht, durch die Maskierungseinrichtung (105) maskiert wird.

2. Eine Datenübertragungsvorrichtung, geeignet, um unter Verwendung eines von einem Cycle-Stealing-Ratio-Dividierer nach Anspruch 1 erzeugten Signals eine Dateneingabe-Datenausgabe durchzuführen.

## Revendications

1. Diviseur de rapport à utilisation en vol de cycles destiné à générer un signal de sortie (S502) de fréquence prédéterminée, comprenant :
un moyen (102) de génération de signal d'horloge destiné à générer un signal d'horloge (S102) d'horloges consécutives à une fréquence prédéterminée,
un moyen de comptage (104) destiné à sortir une contre valeur (S104) comptant les horloges dudit signal d'horloge (S102), dans lequel ladite contre valeur (S104) est remise à l'état initial lors de l'atteinte d'une contre valeur (S101) pré-établie,
un moyen de masquage (105) connecté audit moyen de comptage (104) destiné à recevoir ladite contre valeur (S104) et destiné à sortir ledit signal de sortie (S502), dans lequel ledit moyen de masquage (105) est adapté pour recevoir ledit signal d'horloge (S102) provenant dudit moyen (102) de génération de signal d'horloge et pour recevoir une pluralité de valeurs (S501) de modification de signal d'horloge, dans lequel une horloge dudit signal d'horloge (S102) est masquée par ledit moyen de masquage (105) dans le cas où l'une desdites valeurs (S501) de modification de signal d'horloge est égale à la contre valeur (S104) courante.

2. Appareil de communication adapté pour effectuer des entrées/sorties de données utilisant un signal généré par un diviseur de rapport à utilisation en vol de cycles selon la revendication 1.
